# EUROPEAN PATENT APPLICATION

(11) **EP 4 546 972 A1**
(43) Date of publication of application: **30.04.2025**
(21) Application number: 24208403.6
(22) Date of filing: 23.10.2024
(51) Int. Cl.: H10D 30/47, H10D 64/20, H10D 62/17, H10D 62/85

(54) **A HYBRID ENHANCEMENT/DEPLETION GATE STRUCTURE FOR HIGH ELECTRON MOBILITY TRANSISTOR**

(30) Priority: 24.10.2023 US 202318493660
(71) Applicant: Infineon Technologies Canada Inc., Kanata, Ontario K2V 1C8 (CA)
(72) Inventor: SABUI, Gourab, Kanata, K2V 1C8 (CA); ZUNIGA, Marco A., Kanata, K2V 1C8 (CA); MACELWEE, Thomas William, Kanata, K2V 1C8 (CA); PRASAD, Jayasimha, Kanata, K2V 1C8 (CA); UNNI, Vineet, Kanata, K2V 1C8 (CA)
(74) Representative: Kraus & Lederer PartGmbB

(57) **Abstract**

An HEMT that includes a hybrid gate contact (360) comprising an enhancement gate portion (362) and a depletion gate portion (363). The depletion gate portion acts as a buffer that reduces the large electric field peak that would have otherwise existed at the enhancement gate portion if there was no depletion gate portion. Instead, the large electric field peak is split into two smaller electric field peaks; the first smaller electric field peak being at the drain contact side of the depletion gate portion, and the second smaller electric field peak being at the drain contact side of the enhancement gate portion. The use of this hybrid gate contact allows for greater ability to regulate and reduce electric field peaks, thus allowing the overall size of the HEMT to be reduced, and/or allowing the HEMT to handle higher voltages and currents, as compared to an HEMT with only an enhancement gate.

## Description

### BACKGROUND

Electronic circuits typically include transistors, which function as electronic switches that regulate or control current flow in portions of the circuit. One type of transistor is a field-effect transistor in which a voltage is applied to a gate terminal to turn the transistor on and off. A semiconductor channel region is disposed between the drain terminal and the source terminal. When the transistor is on, current flows through the semiconductor channel region between the source terminal and the drain terminal. When the transistor is off, lesser or no current flows through the semiconductor channel region between the source terminal and the drain terminal. The gate terminal is disposed over the semiconductor channel region between the source terminal and the drain terminal. Voltage on the gate terminal generates a field that affects whether the semiconductor channel region conducts current - hence the term "field-effect transistor".

Silicon has traditionally been used to fabricate transistors. However, wider bandgap semiconductor material may be used to fabricate transistors that conduct higher power and operate at higher efficiency than silicon transistors. Silicon carbide (SiC), Aluminum Nitride (AlN), Zinc Oxide (ZnO), and Gallium Nitride (GaN) are each examples of wide bandgap semiconductor materials that can be used in power electronics. GaN is an example of a semiconductor material which is formed by two layers of different semiconductor materials to therebetween form a heterojunction.

These two semiconductor materials may have sufficiently different bandgaps such that when brought together, the joined bandgap drops below the Fermi level just within the channel layer. This means that electrons may freely flow within this region. This region is thin in depth and forms a plane parallel to the upper surface of the channel region. Thus, this region is called a Two-Dimensional Electron Gas "2DEG" where the term "two-dimensional" emphasizes its planar form, and the term "electron gas" emphasizes 2DEG due to the high mobility of electrons in this region. Thus, the 2DEG region is highly conductive, and is often also called a "sea of electrons". The 2DEG region may form the channel region of a power semiconductor to allow passage of high currents with relatively low resistance. Field-effect transistors that use such a 2DEG are referred to as "High-Electron-Mobility Transistors" (or HEMTs).

The subject matter claimed herein is not limited to embodiments that solve any disadvantages or that operate only in environments such as those described above. Rather, this background is only provided to illustrate one exemplary technology area where some embodiments described herein may be practiced.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

According to an embodiment, a circuit as defined in claim 1 is provided. The dependent claims define further embodiments.

Embodiments described herein relate to a circuit for controlling a high-electron-mobility transistor (an HEMT). The HEMT includes a hybrid gate contact comprising an enhancement gate portion and a depletion gate portion. The circuit further includes a controller that may be used to apply various voltages to the enhancement gate portion and the depletion gate portion. For reasons that will be described, the use of such a hybrid gate contact allows for greater ability to regulate and reduce electric field peaks, thus allowing the overall size of the HEMT to be reduced, and/or allowing the HEMT to handle higher voltages and currents, as compared to an HEMT with only an enhancement gate.

HEMTs are formed by growing an epitaxial layer on a substrate in an epitaxial growth direction. The epitaxial layer includes a channel semiconductor layer and a barrier semiconductor layer that is epitaxially grown on the channel layer. An interface of the barrier layer and the channel layer defines a heterojunction that induces a two-dimensional electron gas (2DEG) within the channel semiconductor layer. This 2DEG extends perpendicular to the epitaxial growth direction. HEMTs also include a source contact and a drain contact, which are each in conductive contact with the 2DEG of the channel layer. Thus, the 2DEG defines a channel of the transistor through which current may flow from the drain contact to the source contact. HEMTs also include a gate contact disposed over the barrier layer in the epitaxial growth direction, the gate contact further being disposed between the source contact and the drain contact perpendicular to the epitaxial growth direction. Voltages applied to the gate contact control whether the 2DEG is continuous or discontinuous between the source contact and the drain contact, and thus controls whether the HEMT is on or off.

Since HEMTs are used to control high voltages and currents, high voltage differences between the gate contact and the drain contact, especially when the HEMT is off, may cause a large electric field peak to be produced in the channel layer on the side of the gate contact more proximate to the drain contact. To help reduce the magnitude of the electric field peak on the drain contact side of the gate contact, the HEMT in accordance with the principles described herein has a hybrid gate contact comprising both an enhancement gate portion and a depletion gate portion in series, with the depletion gate portion being more proximate to the drain contact.

A p-doped semiconductor portion is formed between the enhancement gate portion and the barrier layer in the epitaxial growth direction, such that the 2DEG is discontinuous under the enhancement gate portion when zero volts is applied to the enhancement gate portion. On the other hand, the depletion gate portion causes the 2DEG to be continuous under the depletion gate portion when zero volts is applied to the depletion gate portion. This may be the case, for example, if there is not a p-doped semiconductor portion between the depletion gate portion and the barrier layer.

In addition to the buffering performed by an optional field plate, the depletion gate portion acts as an additional buffer that reduces the large electric field peak that would have otherwise existed at the enhancement gate portion if there was no depletion gate portion. Thus, instead of having a single large electric field peak at the drain side of the enhancement gate portion, the electric field peak is split into two smaller electric field peaks; the first smaller electric field peak being at the drain contact side of the depletion gate portion, and the second smaller electric field peak being at the drain contact side of the enhancement gate portion. Further, the hybrid gate helps reduce the overall magnitude of the electric field in the channel layer near the drain contact, which allows the HEMT to be designed such that the drain contact may be closer to the gate contact, thus allowing the overall size of the HEMT to be reduced. In addition, the reduction of electric field peaks throughout the channel layer allows the HEMT to be used to control higher voltages and currents than would have been possible without the hybrid gate contact.

Additional features and advantages will be set forth in the description which follows, and in part will be obvious from the description, or may be learned by the practice of the teachings herein. Features and advantages of the invention may be realized and obtained by means of the instruments and combinations particularly pointed out in the appended claims. Features of the present invention will become more fully apparent from the following description and appended claims, or may be learned by the practice of the invention as set forth hereinafter.

### BRIEF DESCRIPTION OF THE DRAWINGS

In order to describe the manner in which the above-recited and other advantages and features can be obtained, a more particular description of the subject matter briefly described above will be rendered by reference to specific embodiments which are illustrated in the appended drawings. Understanding that these drawings depict only typical embodiments and are not therefore to be considered to be limiting in scope, embodiments will be described and explained with additional specificity and detail through the use of the accompanying drawings in which:
Figure 1 illustrates a circuit in which the principles described herein may be practiced, and is just one example of a circuit that is consistent with the principles described herein;
Figure 2A illustrates a cross-sectional view of an enhancement mode High-Electron-Mobility Transistor (HEMT);
Figure 2B illustrates an electric field profile diagram corresponding to the HEMT of Figure 2A;
Figure 3A illustrates a cross-sectional view of an HEMT with a hybrid gate contact 360, in accordance with the principles described herein, the HEMT of Figure 3A being an example of an HEMT that may be included in the circuit of Figure 1;
Figure 3B illustrates an electric field profile diagram corresponding to the HEMT of Figure 3A;
Figure 4 illustrates an electric field diagram in which the electric field profiles shown in Figure 2B and Figure 3B are illustrated in superimposed form;
Figure 5A illustrates an example of the enhancement gate contact of the HEMT of Figure 2A;
Figure 5B illustrates an example of the hybrid gate contact of the HEMT of Figure 3A.
Figure 5C illustrates an example embodiment of a hybrid gate contact that may be incorporated into an HEMT; and
Figure 5D illustrates another example embodiment of a hybrid gate contact that may be incorporated into an HEMT.

### DETAILED DESCRIPTION

Embodiments described herein relate to a circuit for controlling a high-electron-mobility transistor (an HEMT). The HEMT includes a hybrid gate contact comprising an enhancement gate portion and a depletion gate portion. The circuit further includes a controller that may be used to apply various voltages to the enhancement gate portion and the depletion gate portion. For reasons that will be described, the use of such a hybrid gate contact allows for greater ability to regulate and reduce electric field peaks, thus allowing the overall size of the HEMT to be reduced, and/or allowing the HEMT to handle higher voltages and currents, as compared to an HEMT with only an enhancement gate.

HEMTs are formed by growing an epitaxial layer on a substrate in an epitaxial growth direction. The epitaxial layer includes a channel semiconductor layer and a barrier semiconductor layer that is epitaxially grown on the channel layer. An interface of the barrier layer and the channel layer defines a heterojunction that induces a two-dimensional electron gas (2DEG) within the channel semiconductor layer. This 2DEG extends perpendicular to the epitaxial growth direction. HEMTs also include a source contact and a drain contact, which are each in conductive contact with the 2DEG of the channel layer. Thus, the 2DEG defines a channel of the transistor through which current may flow from the drain contact to the source contact. HEMTs also include a gate contact disposed over the barrier layer in the epitaxial growth direction, the gate contact further being disposed between the source contact and the drain contact perpendicular to the epitaxial growth direction. Voltages applied to the gate contact control whether the 2DEG is continuous or discontinuous between the source contact and the drain contact, and thus controls whether the HEMT is on or off.

Since HEMTs are used to control high voltages and currents, high voltage differences between the gate contact and the drain contact, especially when the HEMT is off, may cause a large electric field peak to be produced in the channel layer on the side of the gate contact more proximate to the drain contact. To help reduce the magnitude of the electric field peak on the drain contact side of the gate contact, the HEMT in accordance with the principles described herein has a hybrid gate contact comprising both an enhancement gate portion and a depletion gate portion in series, with the depletion gate portion being more proximate to the drain contact.

A p-doped semiconductor portion is formed between the enhancement gate portion and the barrier layer in the epitaxial growth direction, such that the 2DEG is discontinuous under the enhancement gate portion when zero volts is applied to the enhancement gate portion. On the other hand, the depletion gate portion causes the 2DEG to be continuous under the depletion gate portion when zero volts is applied to the depletion gate portion. This may be the case, for example, if there is not a p-doped semiconductor portion between the depletion gate portion and the barrier layer.

In addition to the buffering performed by an optional field plate, the depletion gate portion acts as an additional buffer that reduces the large electric field peak that would have otherwise existed at the enhancement gate portion if there was no depletion gate portion. Thus, instead of having a single large electric field peak at the drain side of the enhancement gate portion, the electric field peak is split into two smaller electric field peaks; the first smaller electric field peak being at the drain contact side of the depletion gate portion, and the second smaller electric field peak being at the drain contact side of the enhancement gate portion. Further, the hybrid gate helps reduce the overall magnitude of the electric field in the channel layer near the drain contact, which allows the HEMT to be designed such that the drain contact may be closer to the gate contact, thus allowing the overall size of the HEMT to be reduced. In addition, the reduction of electric field peaks throughout the channel layer allows the HEMT to be used to control higher voltages and currents than would have been possible without the hybrid gate contact.

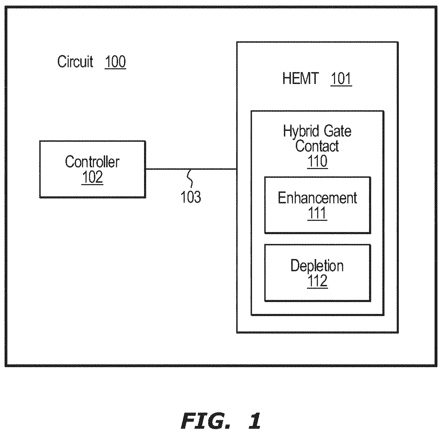

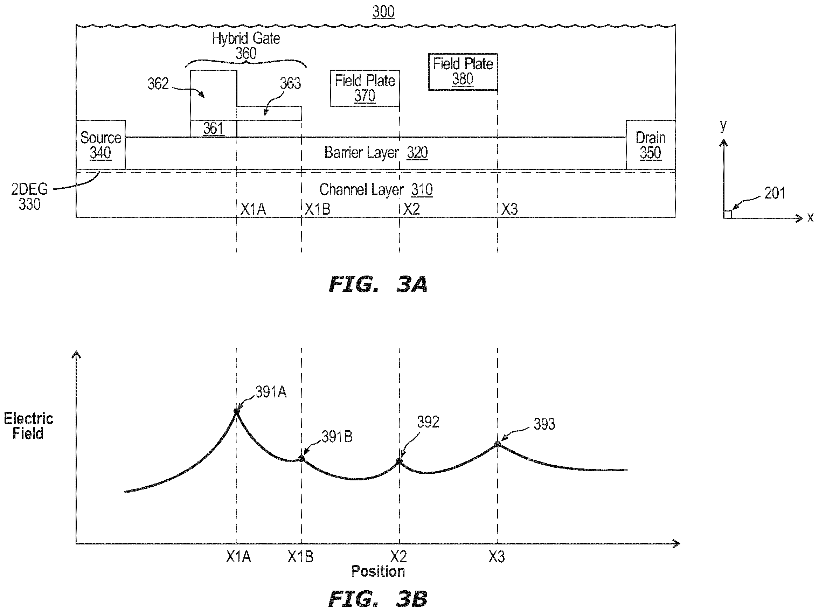

Figure 1 illustrates a circuit 100 in which the principles described herein may be practiced, and is just one example of a circuit that is consistent with the principles described herein. The circuit 100 includes an HEMT 101 and a controller 102 that are electrically connected via a connection 103. The HEMT 101 is abstractly illustrated in Figure 1. A more concrete example of the HEMT 101 will be described with respect to Figure 3A. However, broadly speaking, the HEMT 101 is a field-effect transistor, and thus has a gate contact (e.g., hybrid gate contact 110) that controls whether current flows between a drain contact (not shown in Figure 1) and a source contact (not shown in Figure 1) of the HEMT 101.

More specifically, the gate contact of the HEMT 101 is a hybrid gate contact 110 that includes an enhancement gate portion 111 and a depletion gate portion 112. The controller 102 applies (via the connection 103) various voltages to the hybrid gate contact 110. For example, the controller 102 may apply a turn-on voltage (e.g., positive 6 volts) to the hybrid gate contact 110 to turn on the HEMT 101, whereas the controller 102 may apply a turn-off voltage (e.g., zero volts) to the hybrid gate contact 110 to turn off the HEMT 101. At a high level, the use of the hybrid gate contact 110 allows the HEMT 101 to operate at higher voltage and current limits, and allows the overall size of the HEMT 101 to be reduced, as compared to an HEMT with only an enhancement gate contact. The reasons why these benefits may be achieved, as well as additional example structure and example operation of the HEMT 101, will be explained in greater detail later with respect to Figures 3A and 3B.

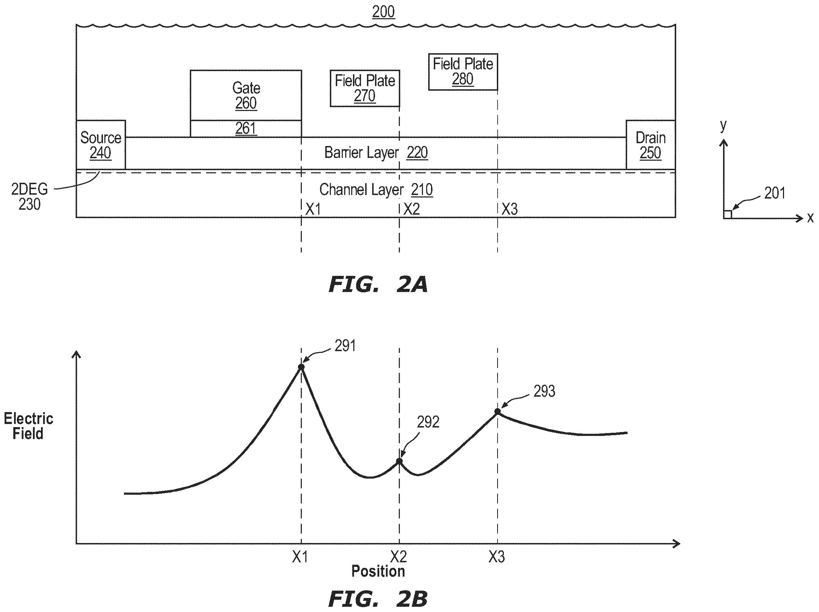

In order to fully understand why the hybrid gate contact 110 of Figure 1 is advantageous, this discussion will now revert to a discussion of how an HEMT with only an enhancement gate contact may operate, with respect to Figures 2A and 2B. Figure 2A illustrates a cross-sectional view of an HEMT 200. Figure 2A further illustrates a coordinate system 201. For convenience and clarity of explanation only, the direction represented by the arrowhead in the y-axis in the coordinate system 201 will be referred to as the direction of epitaxial growth, whereas the x-axis will be referred to as being perpendicular to the direction of epitaxial growth. Accordingly, a direction in the positive y-direction will be sometimes referred to as being in "the epitaxial growth direction", whereas directions parallel to the x-axis will sometimes be referred to as being "perpendicular to the epitaxial growth direction".

The HEMT 200 includes an epitaxial layer comprised of a channel layer 210 and a barrier layer 220 epitaxially grown on the channel layer 210 in the epitaxial growth direction. An interface between the channel layer 210 and the barrier layer 220 defines a heterojunction that induces a two-dimensional electron gas (herein referred to as a "2DEG") 230 within the channel layer 210, through which current may flow when the HEMT 200 is on. This is because the channel layer 210 and the barrier layer 220 are made of different semiconductor materials that have sufficiently different bandgaps such that when connected together, the j oined bandgap drops below the Fermi level just within the channel layer 210, thus forming a region (the 2DEG 230) of high electron concentration. As an example only, if the channel layer 210 is composed of Gallium-Nitride (GaN), and the barrier layer 220 is composed of Aluminum-Gallium-Nitride (AlGaN), the bandgap differences would be sufficient to generate a 2DEG 230. However, the principles described herein are not limited to the types of semiconductor materials that the channel layer 210 and the barrier layer 220 are composed of.

The HEMT 200 further includes a source contact 240, a drain contact 250, and a gate contact 260. The source contact 240 and the drain contact 250 are disposed on opposite ends (perpendicular to the epitaxial growth direction) of the 2DEG 230. More specifically, in Figure 2A, the source contact 240 is disposed over the left of the top surface of the 2DEG 230, whereas the drain contact 250 is disposed over the right of the top surface of the 2DEG 230.

The gate contact 260 is disposed over the barrier layer 220 in the epitaxial growth direction, and is disposed between the source contact 240 and the drain contact 250 perpendicular to the epitaxial growth direction. A portion of the 2DEG 230 below the gate contact 260 is affected by voltage applied to the gate contact 260. For example, when the HEMT 200 is on, the 2DEG region 230 is continuous below the gate contact 260, thus allowing current to freely flow between the drain contact 250 and the source contact 240. However, when the HEMT 200 is off, the 2DEG region 230 is discontinuous below the gate contact 260, thus blocking current from flowing between the drain contact 250 and the source contact 240.

The HEMT 200, acting as an enhancement mode HEMT, includes a p-doped semiconductor portion 261 between the gate contact 260 and the barrier layer 220 in the epitaxial growth direction. The p-doped semiconductor portion 261 causes the 2DEG 230 to be discontinuous under the gate contact 260 when zero volts is applied to the gate contact 260. Thus, in order to cause the 2DEG 230 under the gate contact 260 to become continuous, and thus to turn on the HEMT 200, a sufficiently positive voltage is applied to the gate contact 260. As an example, the sufficiently positive voltage may be a voltage that is greater than a gate-to-source threshold voltage of the HEMT 200.

As previously expressed, HEMTs are used to control high voltages and currents. Thus, while the HEMT 200 is off, the source contact 240 and the gate contact 260 may have zero volts applied thereto, and a large positive voltage (e.g., hundreds of volts) may be present at the drain contact 250. The large voltage difference between the drain contact 250 and the gate contact 260 may induce large electric field peaks within the channel layer 210, particularly at the drain side of the gate contact 260, as illustrated at position X1. To illustrate this point, Figure 2B illustrates an electric field profile diagram corresponding to the HEMT 200 of Figure 2A. Horizontal positions are aligned in Figures 2A and 2B such that the electric field occurring at each horizontal position in Figure 2A is represented by the electric field charted immediately below in Figure 2B. In order to explain why large electric fields are produced, a brief explanation of electric fields will now be described.

The magnitude of an electric field between two points of different voltages is proportional to the magnitude of that voltage difference and inversely proportional to the distance between the two points. When a positive voltage is applied on the drain, the voltage drops from the drain edge to the p-gate edge. The electric field is directly proportional to the voltage applied, and as the voltage increases the electric field also increases. HEMTs are meant to withstand a high voltage from drain to gate which means withstanding a large electric field. At the edge of the gate, due to the abrupt nature of the p-gate termination, electric field lines tend to crowd and cause e-field peaks.

Problems can occur in an HEMT if the electric field peaks are too large. For example, in the HEMT 200 of Figure 2A, if the electric field peak 291 at position X1 was too large, it would cause the HEMT 200 to degrade relatively quickly. This is partially due to large electric field peaks at the drain side of the gate contact 260 causing "gate current leakage", in which some electrons pass through the barrier layer 220 under the gate contact 260, and a small current is induced between the gate contact 260 and the drain contact 250. This causes HEMT degradation and faster aging of the HEMT. To prevent large electric field peaks, field plates may be used.

For example, the HEMT 200 of Figure 2A includes field plates 270 and 280. The field plates 270 and 280 are each disposed over the barrier layer 220 in the epitaxial growth direction, but are each further from the 2DEG 230 than the gate contact 260 is from the 2DEG 230 in the epitaxial growth direction. As a side note, the areas underneath the field plates 270 and 280 in the epitaxial growth direction, as well as the areas between the remainder of the elements of the HEMT 200, may be comprised of a dielectric material that assists in structural stability and electrical isolation between the elements of the HEMT 200. Each of the field plates 270 and 280 may be grounded, or may have a voltage applied thereto. In any case, because of the increased distance between the field plates and the 2DEG 230, the field plates 270 and 280 each act as a buffer that helps to reduce the voltage present in the channel layer 210 approaching position X1. Field plates prevent the e-field crowding at the p-gate edge and instead of one large peak, the voltage is now spread between successive field plates each with successively lower e-field peaks. So, instead of having a single very high e-field peak which leads to a weakness of the device in location X1, now the e-field is better distributed without any single location of failure.

That is, while there is indeed an electric field peak 291 at the drain side of the gate contact 260 at position X1, the electric field peak 291 is reduced compared to what it would have been if the HEMT 200 did not include the field plates 270 and 280. This is because, moving leftwards from the drain contact 250 towards the gate contact 260, the distance between the 2DEG 230 and the field plate 280 reaches a minimum, and thus a smaller electric field peak 293 is induced in the channel layer 210 at the drain side of the field plate 280, at position X3. Thus, the voltage in the channel layer 210 under the field plate 280 and moving leftward is reduced. Continuing leftwards from the field plate 280, the distance between the 2DEG 230 and the field plate 270 reaches a minimum, and thus another small electric field peak 292 is induced in the channel layer 210 at the drain side of the field plate 270, at position X2. Thus, the voltage in the channel layer 210 under the field plate 270 and moving leftward is even further reduced. Finally, continuing leftwards from the field plate 270, the distance between the 2DEG 230 and the gate contact 260 reaches a minimum, and thus the reduced electric field peak 291 is induced at position X1.

While the field plates 270 and 280 do indeed help to reduce the magnitude of the electric field peak that would have otherwise been induced at the drain side of the gate contact 260, the electric field peak 291 is still significant. Accordingly, the HEMT 200 would benefit from having the electric field peak 291 further reduced.

This could be accomplished, for example, by adding additional field plates between the gate contact 260 and the drain contact 250. However, the number of field plates that may be added between the gate contact 260 and the drain contact 250 is limited, in part, by the distance between the gate contact 260 and the drain contact 250. Thus, in order to add more field plates, the distance between the gate contact 260 and the drain contact 250 would be increased, and thus the overall size of the HEMT 200 would be increased. Increasing the overall size of the HEMT 200 would result in increased cost to produce the HEMT 200, as fewer instances of the HEMT 200 could be manufactured on the same size of semiconductor wafer.

The inventors have created an HEMT that includes a hybrid gate contact that allows for greater ability to regulate and reduce electric field peaks, particularly at the hybrid gate contact, without increasing the size of the HEMT. In fact, the hybrid gate contact according to the principles described herein allows the overall size of the HEMT to be reduced, as well as allows the HEMT to handle higher voltages and currents, as compared to the HEMT 200 of Figure 2A that only uses the enhancement gate contact 260.

Figure 3A illustrates a cross-sectional view of an HEMT 300 with a hybrid gate contact 360, in accordance with the principles described herein. As an example, the HEMT 300 of Figure 3A is an example of the HEMT 101 of Figure 1. Thus, as an example only, voltages applied to the hybrid gate contact 360 of Figure 3A may be applied by the controller 102 via the connection 103 of Figure 1. Below Figure 3A, Figure 3B is an electric field profile diagram corresponding to the HEMT 300 of Figure 3A. Horizontal positions are aligned in Figures 3A and 3B, such that the electric field occurring at each horizontal position in Figure 3A is represented by the electric field charted immediately below in Figure 3B. Furthermore, for purposes of consistency, Figure 3A uses the coordinate system 201 of Figure 2A.

For purposes of the embodiment of Figure 3A (but not limiting the broader aspects described herein), suppose that the channel layer 310, the barrier layer 320, the 2DEG 330, the source contact 340, the drain contact 350, and the field plates 370 and 380 have the same structure as described above in reference to Figure 2A with respect to the corresponding channel layer 210, the barrier layer 220, the 2DEG 230, the source contact 240, the drain contact 250, and the field plates 270 and 280. That being said, the application of the principles described herein allows for greater flexibility in how HEMTs are structured and sized.

For purposes of explanation, the overall length of the hybrid gate contact 360, perpendicular to the epitaxial growth direction, is approximately the same as the length of the gate contact 260 of Figure 2A. However, the hybrid gate contact 360 of Figure 3A differs from the gate contact 260 of Figure 2A in other aspects. That is, the hybrid gate contact 360 includes an enhancement gate portion 362 and a depletion gate portion 363. The hybrid gate contact 360 also includes a p-doped semiconductor portion 361 between the enhancement gate portion 362 and the barrier layer 320 in the epitaxial growth direction. However, there is no such p-doped semiconductor portion under the depletion gate portion 363. Thus, the p-doped portion 361 causes the 2DEG 330 to be discontinuous, only under the enhancement gate portion 362, when zero volts is applied to the hybrid gate contact 360.

Further, because there is no p-doped semiconductor portion under the depletion gate portion 363, the 2DEG 330 under the depletion gate portion 363 is continuous when zero volts is applied to the hybrid gate contact 360. Accordingly, the depletion gate portion 363 functions as a buffer that further decreases the electric field peak that would have otherwise existed at the drain side of the enhancement gate portion 362. Note however, that the depletion gate portion 363 is capable of reducing the magnitude of the electric field peak at the drain side of the enhancement gate portion 362 without increasing the overall size of the HEMT 300, as the overall length (perpendicular to the epitaxial growth direction) of the hybrid gate contact 360 is approximately the same as the length of the gate contact 260 of Figure 2A.

Regarding the electric field profile diagram of Figure 3B, suppose that the HEMT 300 is off, such that the source contact 340 and the hybrid gate contact 360 have zero volts applied thereto, and a large positive voltage is present at the drain contact 350. For purposes of comparison, assume that the large positive voltage present at the drain contact 350 is the same large positive voltage present at the drain contact 250 of Figure 2A. Similar to the field plates 270 and 280 of Figure 2A, the field plates 370 and 380 each act as a buffer that helps to reduce the voltage present in the channel layer 310 approaching the hybrid gate contact 360 from the right.

That is, moving leftwards from the drain contact 350 towards the hybrid gate contact 360, the distance between the 2DEG 330 and the field plate 380 reaches a minimum, and thus a small electric field peak 393 is induced in the channel layer 310 at the drain side of the field plate 380, at position X3. Thus, the voltage in the channel layer 310 under the field plate 380 and moving leftward is reduced. Continuing leftwards from the field plate 380, the distance between the 2DEG 330 and the field plate 370 reaches a minimum, and thus another small electric field peak 392 is induced in the channel layer 310 at the drain side of the field plate 370, at position X2. Thus, the voltage in the channel layer 310 under the field plate 370 and moving leftward is even further reduced.

Continuing leftwards from the field plate 370, the distance between the 2DEG 330 and the depletion gate portion 363 reaches a minimum, and thus another small electric field peak 391B is induced in the channel layer 310 at the drain side of the depletion gate portion 363, at position X1B. Thus, the voltage in the channel layer 310 under the depletion gate portion 363 and moving leftward is even further reduced. Finally, continuing leftwards from the depletion portion 363, the voltage in the channel layer 310 has been reduced such that, at a minimum distance between the 2DEG 330 and the enhancement gate portion 362, a much smaller electric field peak 391A is induced at the drain side of the enhancement gate portion 362, as compared to the electric field peak 291 of Figure 2B induced at the drain side of the gate contact 260 of Figure 2A. Accordingly, because the overall magnitude of the electric field peaks are reduced, particularly at the drain side of the enhancement gate portion 362, the hybrid gate contact 360 according to the principles described herein allows the HEMT 300 to be operated at higher voltages and currents without causing damage to the HEMT 300.

In addition, while the hybrid gate contact 360 allows for reduction in electric field peaks, the inventors have also discovered that using the hybrid gate contact 360 further decreases the electric field in the channel layer 310 near the drain contact 350. The operation of an HEMT is significantly impacted by the magnitude of electric field peaks and the magnitude of the electric field proximate to the drain contact. For example, large electric fields closer to the drain contact can have more adverse impact on the performance of an HEMT.

Thus, because using the hybrid gate contact 360 decreases the electric field in the channel layer 310 near the drain contact 350, and also because using the hybrid gate contact 360 significantly reduces the magnitude of electric field peaks in the channel region as previously described, the overall size of the HEMT 300 can be reduced as compared to the HEMT 200 that does not have the hybrid gate contact 360. That is, the distance between the drain contact 350 and the hybrid gate contact 360 may be reduced, while still allowing the HEMT 300 to stay within adequate performance margins. Accordingly, more instances of the HEMT 300 of Figure 3A may be manufactured on the same size semiconductor wafer, thus reducing manufacturing costs.

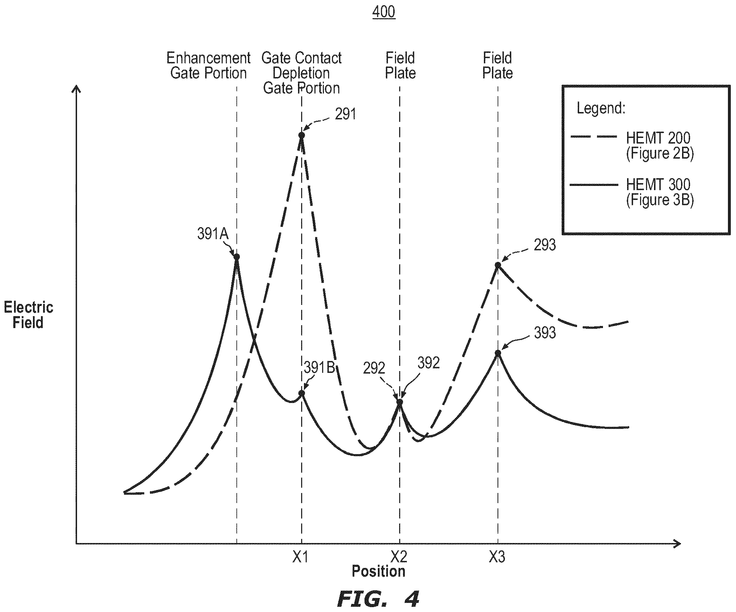

For purposes of explanation and comparison, Figure 4 illustrates an electric field diagram 400 in which the electric field profiles shown in Figure 2B and Figure 3B are illustrated in superimposed form. The electric field profile of the HEMT 200 of Figure 2A is represented in dashed-line form. The electric field profile of the HEMT 300 of Figure 3A is represented in solid-line form. Further, the positions X1, X1A, X1B, X2 and X3 are illustrated as vertical dashed lines. As illustrated in Figure 4, the magnitude of the electric field peak 391A of the HEMT 300 at position X1A is substantially smaller than the electric field peak 291 of the HEMT 200 at position X1. Further, notice that the electric field (see electric field peak 393 and rightwards of that peak) generally around the drain contact 350 of the HEMT 300 is also smaller than the electric field (see electric field peak 293 and rightwards of that peak) around the drain contact 250 of the HEMT 200. Thus, using the hybrid gate contact 360 of the HEMT 300 significantly reduces the electric field peaks, particularly near the hybrid gate contact 360, and also reduces the electric field in general around the drain contact 350. Accordingly, the hybrid gate contact 360 of Figure 3A allows the overall size of the HEMT 300 to be reduced, while also allowing the HEMT 300 to operate at higher voltage and current limits.

The degree to which the hybrid gate portion 363 decreases the electric field peaks and overall electric field near the drain contact 350 can be adjusted by changing the dimensions of the hybrid gate contact 360. For example, in Figure 3A, the depletion gate portion 363 is thinner than the enhancement gate portion 362 in the epitaxial growth direction.

Further, the depletion gate portion 363 is longer than the enhancement gate portion 362 perpendicular to the epitaxial growth direction. While keeping the overall length of the hybrid gate contact 360 perpendicular to the epitaxial growth direction the same, increasing the length of the depletion gate portion 363, to an extent, also helps to provide a more robust electric field buffer for the enhancement gate portion 362.

However, while keeping the overall length of the hybrid gate contact 360 the same, increasing the length of the depletion gate portion 363 would mean decreasing the length of the enhancement gate portion 362. Decreasing the length of the enhancement gate portion 362 would thereby mean decreasing the length of the p-doped semiconductor portion 361 perpendicular to the epitaxial growth direction. Decreasing the length of the p-doped semiconductor portion 361 would cause a smaller portion of the 2DEG 330 under the enhancement gate portion 362 to be discontinuous while the HEMT 300 is off. On one hand, this allows for reduced on-resistance, which allows the HEMT 300 to operate with higher currents. On the other hand, reducing the portion of the 2DEG 330 that is discontinuous while the HEMT 300 is off would also cause the HEMT 300 to have increased leakage current. Taking this concept to its logical end, if the depletion gate portion 363 was long enough so that there was little or no enhancement gate portion 362, the leakage current would be so significant that the HEMT 300 would operate as a depletion mode HEMT, conducting current when zero volts is applied to the hybrid gate contact 360. Accordingly, while the length of the depletion gate portion 363 may be, to some extent, adjusted so as to adjust electric field peaks in the channel layer 310, there is a tradeoff between current load capabilities and leakage current problems in the HEMT 300.

The principles described herein are not limited to the particular HEMT 300 of Figure 3A. In fact, the hybrid gate that has been described with respect to Figure 3A may be incorporated into many different field-effect transistors. In addition, there are multiple additional embodiments of the hybrid gate that would be beneficial for use in HEMTs such as the HEMT 300 of Figure 3A.

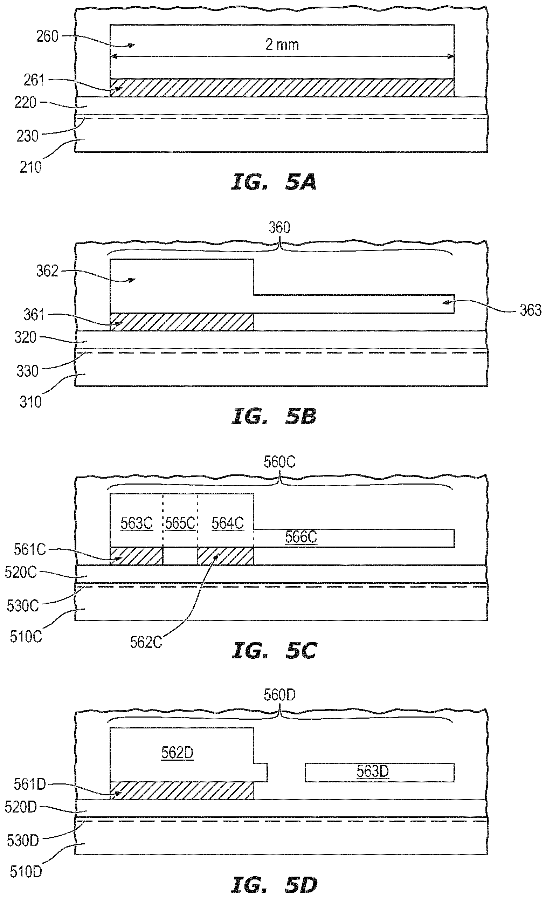

For purposes of comparison, Figure 5A illustrates an example of the enhancement gate contact 260 of Figure 2A, and Figure 5B illustrates an example of the hybrid gate contact 360 of Figure 3A. Figures 5C and 5D each illustrate additional example embodiments of two alternative hybrid gate contacts. For purposes of simplicity, the channel layer, barrier layer, 2DEG, gate contact (including corresponding enhancement / depletion gate portions for Figure 3A) and p-doped semiconductor portion in each of Figures 5A and 5B are labelled with the same element numbers as their respective corresponding Figures 2A and 3A. To help illustrate the differences between the various enhancement gate portions and depletion gate portions of Figures 5A through 5D, the p-doped semiconductor portions are illustrated as being filled in with hashed markings.

Further, in each of Figures 5A through 5D, suppose that the overall length of each hybrid gate contact, perpendicular to the epitaxial growth direction, is the same. For example, the overall length of each hybrid gate contact, perpendicular to the epitaxial growth direction, may be 2 µm (microns). For example, suppose that the overall length of the enhancement gate contact 260 of Figure 5A is 2 µm. In addition, suppose that the hybrid gate contact 360 of Figure 5B is 2 µm, split up into the enhancement gate portion 362 having a length of 0.8 µm, and the depletion gate portion having a length of 1.2 µm.

Figure 5C illustrates a hybrid gate contact 560C that is disposed over a substrate comprising a channel layer 510C and a barrier layer 520C. The channel layer 510C and the barrier layer 520C together form a 2DEG 530C within the channel layer 510C. The hybrid gate contact 560C includes two enhancement gate portions 563C and 564C, and two depletion gate portions 565C and 566C. Divisions between each of these gate portions 563C through 566C are illustrated using vertical dotted lines. Under the two enhancement gate portions 563C and 564C are respective p-doped semiconductor portions 561C and 562C. Note that the enhancement gate portions 563C and 564C, along with the depletion gate portion 565C, together take substantially the same shape as the enhancement gate portion 362 of Figure 5B, whereas the depletion gate portion 566C takes substantially the same shape as the depletion gate portion 363 of Figure 5B. Alternatively, the hybrid gate contact 560C of Figure 5C could be thought of as a single enhancement gate portion and a single depletion gate portion, as is the hybrid gate contact 360 of Figure 5B, except having multiple distinct p-doped semiconductor portions under the enhancement gate portion.

A hybrid gate contact with various enhancement gate portions and depletion gate portions (or multiple p-doped semiconductor portions underneath an enhancement gate portion), such as the hybrid gate contact 560C of Figure 5C, may help to further reduce any large electric field peaks at the hybrid gate contact 560C into various smaller electric field peaks. Thus, the hybrid gate contact 560C of Figure 5C may also allow the overall size of its HEMT to be reduced, and allow for its HEMT to operate at higher voltage and current limits.

Figure 5D illustrates a hybrid gate contact 560D. The hybrid gate contact 560D is disposed over a substrate comprising a channel layer S 10D and a barrier layer 520D. The channel layer 510D and the barrier layer 520D together form a 2DEG 530D within the channel layer 510D. The hybrid gate contact 560D includes an enhancement gate portion 562D and a depletion gate portion 563D. Under the enhancement gate portion 562D is a p-doped semiconductor portion 561D. The hybrid gate contact 560D takes substantially the same shape as the hybrid gate contact 360 of Figure 5B, except that the enhancement gate portion 562D and the depletion gate portion 563D are disconnected from each other.

Having the enhancement gate portion 562D and the depletion gate portion 563D disconnected from each other allows for further manipulation of electric fields. That is, different voltages may be applied to the enhancement gate portion 562D and the depletion gate portion 563D such that the depletion gate portion 563D may be adjusted so as to function as a stronger buffer or a weaker buffer for the enhancement gate portion 562D. For example, even while an HEMT that includes the hybrid gate contact 560D is off, such that zero volts is applied to the enhancement gate portion 562D, a voltage besides zero volts may be applied to the depletion gate portion 563D. Such voltages may be applied to the enhancement gate portion 562D and the depletion gate portion 563D by the controller 102 via the connection 103 of Figure 1. Further, different voltages may be applied to the enhancement gate portion 562D and the depletion gate portion 563D with some time delay (e.g., 20 nanoseconds) therebetween. This may be beneficial, for example, when turning on the HEMT that includes the hybrid gate contact 560D. Accordingly, the hybrid gate contact 560D allows for greater flexibility in manipulating electric fields, thus further allowing the overall size of its HEMT to be reduced, and allowing its HEMT to operate at higher voltage and current limits.

Accordingly, what has been described is a circuit for controlling an HEMT. The HEMT includes a hybrid gate contact comprising an enhancement gate portion and a depletion gate portion. The circuit further includes a controller that may apply voltages to the enhancement gate portion and the depletion gate portion. The use of the hybrid gate contact allows for greater ability to regulate and reduce electric field peaks, thus allowing the overall size of the HEMT to be reduced, and/or allowing the HEMT to handle higher voltages and currents, as compared to an HEMT with only an enhancement gate.

### Literal Support Section

Clause 1. A circuit comprising a high-electron-mobility transistor and a controller, the high-electron-mobility transistor comprising: an epitaxial layer epitaxially grown on a substrate in an epitaxial growth direction, the epitaxial layer comprising a channel semiconductor layer and a barrier semiconductor layer epitaxially grown on the channel semiconductor layer, an interface of the barrier semiconductor layer and the channel semiconductor layer defining a heterojunction that induces a two-dimensional electron gas (2DEG) within the channel semiconductor layer, the 2DEG extending perpendicular to the epitaxial growth direction; a source contact that is in conductive contact with a first portion of the 2DEG; a drain contact that is in conductive contact with a second portion of the 2DEG; a gate contact disposed over the barrier semiconductor layer in the epitaxial growth direction, and being disposed between the drain contact and the source contact in a direction perpendicular to the epitaxial growth direction, the gate contact comprising an enhancement gate portion and a depletion gate portion, the depletion gate portion being disposed between the enhancement gate portion and the drain contact in the direction perpendicular to the epitaxial growth direction; and a p-doped semiconductor portion between the enhancement gate portion and the barrier semiconductor layer in the epitaxial growth direction, such that the 2DEG is discontinuous under the enhancement gate portion when zero volts is applied to the enhancement gate portion, the depletion gate portion being configured such that the 2DEG is continuous under the depletion gate portion when zero volts is applied to the depletion gate portion.

Clause 2. The circuit according to Clause 1, the enhancement gate portion and the depletion gate portion being disconnected.

Clause 3. The circuit according to Clause 2, the controller configured to at least sometimes apply a different voltage to the enhancement gate portion than is applied to the depletion gate portion.

Clause 4. The circuit according to Clause 3, the controller configured to apply at least a turn-on voltage to the enhancement gate portion to thereby turn on the high-electron-mobility transistor, and further configured to apply a voltage to the depletion gate portion within a certain delay after applying the turn-on voltage to the enhancement gate portion.

Clause 5. The circuit according to Clause 1, the certain delay being 20 nanoseconds or less.

Clause 6. The circuit according to Clause 1, the enhancement gate portion and the depletion gate portion being electrically connected together.

Clause 7. The circuit according to Clause 6, the controller configured to apply at least a turn-on voltage to the enhancement gate portion to thereby turn on the high-electron-mobility transistor, the controller further configured to apply the turn-on voltage to the connected depletion gate portion.

Clause 8. The circuit according to Clause 1, a thickness of the enhancement gate portion being greater than a thickness of the depletion gate portion in the epitaxial growth direction.

Clause 9. The circuit according to Clause 1, a length of the enhancement gate portion being shorter than a length of the depletion gate portion in the direction perpendicular to the epitaxial growth direction.

Clause 10. The circuit according to Clause 1, the channel layer being a Gallium-Nitride (GaN) channel layer.

Clause 11. The circuit according to Clause 1, the barrier layer being an Aluminum-Gallium-Nitride (AlGaN) layer.Although the subject matter has been described in language specific to structural features and/or methodological acts, it is to be understood that the subject matter defined in the appended claims is not necessarily limited to the described features or acts described above, or the order of the acts described above. Rather, the described features and acts are disclosed as example forms of implementing the claims.

The present disclosure may be embodied in other specific forms without departing from its essential characteristics. The described embodiments are to be considered in all respects only as illustrative and not restrictive. All changes which come within the meaning and range of equivalency of the claims are to be embraced within their scope.

When introducing elements in the appended claims, the articles "a," "an," "the," and "said" are intended to mean there are one or more of the elements. The terms "comprising," "including," and "having" are intended to be inclusive and mean that there may be additional elements other than the listed elements.

## Claims

1. A circuit comprising a high-electron-mobility transistor and a controller, the high-electron-mobility transistor comprising:
an epitaxial layer epitaxially grown on a substrate in an epitaxial growth direction, the epitaxial layer comprising a channel semiconductor layer and a barrier semiconductor layer epitaxially grown on the channel semiconductor layer, an interface of the barrier semiconductor layer and the channel semiconductor layer defining a heterojunction that induces a two-dimensional electron gas (2DEG) within the channel semiconductor layer, the 2DEG extending perpendicular to the epitaxial growth direction;
a source contact that is in conductive contact with a first portion of the 2DEG;
a drain contact that is in conductive contact with a second portion of the 2DEG;
a gate contact disposed over the barrier semiconductor layer in the epitaxial growth direction, and being disposed between the drain contact and the source contact in a direction perpendicular to the epitaxial growth direction, the gate contact comprising an enhancement gate portion and a depletion gate portion, the depletion gate portion being disposed between the enhancement gate portion and the drain contact in the direction perpendicular to the epitaxial growth direction; and
a p-doped semiconductor portion between the enhancement gate portion and the barrier semiconductor layer in the epitaxial growth direction, such that the 2DEG is discontinuous under the enhancement gate portion when zero volts is applied to the enhancement gate portion, the depletion gate portion being configured such that the 2DEG is continuous under the depletion gate portion when zero volts is applied to the depletion gate portion.

2. The circuit according to Claim 1, the enhancement gate portion and the depletion gate portion being disconnected.

3. The circuit according to Claim 2, the controller configured to at least sometimes apply a different voltage to the enhancement gate portion than is applied to the depletion gate portion.

4. The circuit according to Claim 3, the controller configured to apply at least a turn-on voltage to the enhancement gate portion to thereby turn on the high-electron-mobility transistor, and further configured to apply a voltage to the depletion gate portion within a certain delay after applying the turn-on voltage to the enhancement gate portion.

5. The circuit according to Claim 1, the enhancement gate portion and the depletion gate portion being electrically connected together.

6. The circuit according to Claim 5, the controller configured to apply at least a turn-on voltage to the enhancement gate portion to thereby turn on the high-electron-mobility transistor, the controller further configured to apply the turn-on voltage to the connected depletion gate portion.

7. The circuit according to any one of Claims 1 to 6, the certain delay being 20 nanoseconds or less.

8. The circuit according to any one of Claims 1 to 7, a thickness of the enhancement gate portion being greater than a thickness of the depletion gate portion in the epitaxial growth direction.

9. The circuit according to any one of Claims 1 to 8, a length of the enhancement gate portion being shorter than a length of the depletion gate portion in the direction perpendicular to the epitaxial growth direction.

10. The circuit according to any one of Claims 1 to 9, the channel layer being a Gallium-Nitride (GaN) channel layer.

11. The circuit according to any one of Claims 1 to 10, the barrier layer being an Aluminum-Gallium-Nitride (AlGaN) layer.
